# EUROPEAN PATENT SPECIFICATION

(11) **EP 1 332 649 B1**
(45) Date of publication and mention of the grant of the patent: **24.03.2010**
(21) Application number: 01976963.7
(22) Date of filing: 12.10.2001
(51) Int. Cl.: H05G 2/00

(54) **METHOD AND APPARATUS FOR GENERATING X-RAY OR EUV RADIATION**
VERFAHREN UND VORRICHTUNG ZUR ERZEUGUNG VON RÖNTGEN- ODER EUV-STRAHLUNG
PROCEDE ET DISPOSITIF DE PRODUction de RAYONs X OU de RAYONNEMENT EUV

(30) Priority: 13.10.2000 SE 0003715
(43) Date of publication of application: 06.08.2003
(73) Proprietor: Jettec AB, 182 79 Stocksund (SE)
(72) Inventor: HERTZ, Hans, Martin, S-182 79 Stocksund (SE); HEMBERG, Oscar, S-113 26 Stockholm (SE); HANSSON, Björn, A., M., S-115 43 Stockholm (SE); BERGLUND, Magnus, S-295 94 Axeltorp (SE); RYMELL, Lars, S-112 44 Stockholm (SE)
(74) Representative: Henningsson, Gunnar
(86) International application number: PCT/SE2001/002217
(87) International publication number: WO 2002/032197

(56) References cited:
- EP-B1- 1 222 842
- WO-A1-97/40650
- US-A- 5 577 092

## Description

### Technical Field

The present invention generally relates to a method and an apparatus for generating X-ray or EUV radiation, i.e. radiation in the wavelength region of approximately 0.01-100 nm. The generated radiation can be used in any application requiring X-ray or EUV radiation, for example lithography, microscopy, materials science, or medical diagnostics.

### Background Art

EUV and X-ray sources of high intensity are applied in many fields, for instance surface physics, materials testing, crystal analysis, atomic physics, medical diagnostics, lithography and microscopy. Conventional X-ray sources, in which an electron beam is brought to impinge on an anode, generate a relatively low X-ray intensity. Large facilities, such as synchrotron light sources, produce a high average power. However, there are many applications that require compact, small-scale systems which produce a relatively high average power. Compact and more inexpensive systems yield better accessibility to the applied user and thus are of potentially greater value to science and society. An example of an application of particular industrial importance is future narrow-line-width lithography systems.

Ever since the 1960s, the size of the structures that constitute the basis of integrated electronic circuits has decreased continuously. The advantage thereof is faster and more complicated circuits needing less power. At present, photolithography is used to industrially produce such circuits having a line width of about 0.18 µm with projected extension towards 0.10-0.13 µm. In order to further reduce the line width, other methods will probably be necessary, of which EUV projection lithography is a very interesting candidate and X-ray lithography may become interesting for certain technological niches. In EUV projection lithography, use is made of a reducing extreme ultraviolet (EUV) objective system in the wavelength range around 10-20 nm ("EUV Lithography - The Successor to Optical Lithography?" by Bjorkholm, published in Intel Technology Journal Q3'98). Proximity X-ray lithography, employing a contact copy scheme, is carried out in the wavelength range around 1 nm (see for instance the article "X-ray Lithography" by Maldonado, published in J. Electronic Materials 19, p. 699, 1990).

Laser plasmas are attractive table-top X-ray and EUV sources due to their high brightness, high spatial stability and, potentially, high-repetition rate. However, with conventional bulk or tape targets, the operating time is limited, especially when high-repetition-rate lasers are used, since fresh target material cannot be supplied at a sufficient rate. Furthermore, such conventional targets produce debris which may destroy or coat sensitive components such as X-ray optics or EUV multilayer mirrors positioned close to the plasma. Several methods have been designed to eliminate the effect of debris, i.e., preventing the already produced debris from reaching the sensitive components. As an alternative, the amount of debris actually produced can be limited by replacing conventional solid targets with for example gas targets, gas-cluster targets, liquid-droplet targets, or liquid-jet targets.

Targets in the form of microscopic liquid droplets, such as disclosed in the article "Droplet target for low-debris laser-plasma soft X-ray generation" by Rymell and Hertz, published in Opt. Commun. 103, p. 105, 1993, are attractive low-debris, high-density targets potentially capable of high repetition-rate laser-plasma operation with high-brightness emission. Such droplets are generated by stimulated breakup of a liquid jet which is formed at a nozzle in a low-pressure chamber. However, the hydrodynamic properties of certain fluids result in unstable drop formation. Furthermore, the operation of the laser must be carefully synchronized with the droplet formation. Another problem may arise in the use of liquid substances with rapid evaporation, namely that the jet freezes immediately upon generation so that drops cannot be formed. Such substances primarily include media that are in a gaseous state at normal pressure and temperature and that are cooled to a liquid state for generation of the droplet targets. To ensure droplet formation, it is necessary to provide a suitable gas atmosphere in the low-pressure chamber, or to raise the temperature of the jet above its freezing temperature by means of an electric heater provided around the jet, such as disclosed in the article "Apparatus for producing uniform solid spheres of hydrogen" by Foster et al., published in Rev. Sci. Instrum. 6, pp 625-631, 1977.

As an alternative, as known from US-A-6 002 744, which is incorporated herein by reference, the laser radiation is instead focused on a spatially continuous portion of a jet which is generated by urging a liquid substance through an outlet or nozzle. This liquid-jet approach alleviates the need for temporal synchronization of the laser with the generation of the target, while keeping the production of debris equally low as from droplet targets. Furthermore, liquid substances having unsuitable hydrodynamic properties for droplet formation can be used in this approach. Another advantage over the droplet-target approach is that the spatially continuous portion of the jet can be allowed to freeze. Such a liquid-jet laser-plasma source has been further demonstrated in the article "Cryogenic liquid-jet target for debris-free laser-plasma soft x-ray generation" by Berglund et al, published in Rev. Sci. Instrum. 69, p. 2361, 1998, and the article "Liquid-jet target laser-plasma sources for EUV and X-ray lithography" by Rymell et al, published in Microelectronic Engineering 46, p. 453, 1999, by using liquid nitrogen and xenon, respectively, as target material. In these cases, a high-density target is formed as a spatially continuous portion of the jet, wherein the spatially continuous portion can be in a liquid or a frozen state. Such laser-plasma sources have the advantage of being high-brightness, low-debris sources capable of continuous high-repetition-rate operation, and the plasma can be produced far from the outlet orifice, thereby limiting plasma-induced erosion of the outlet. Such erosion may be a source of damaging debris. Further, by producing the plasma far from the outlet, self-absorption of the generated radiation can be minimized. This is due to the fact that the temperature around the jet decreases with the distance from the outlet, resulting in a correspondingly decreasing evaporation rate. Thus, the local gas atmosphere around the jet also decreases with the distance from the outlet.

However, many substances, and in particular liquid substances formed by cooling normally gaseous substances, yield a jet that experiences stochastic changes in its direction from the jet-generating outlet. Typically the change in direction can be as large as about ±1° and occurs a few times per minute to a few times per second. This in turn results in a spatial instability at the focus of the laser beam, i.e. at the desired area of beam-jet-interaction, which should be as far away from the outlet orifice as possible for the reasons given above. The spatial instability leads to high pulse-to-pulse fluctuations in the emitted X-ray and EUV radiation flux and spatial instability of the radiating plasma. Furthermore, the average power is significantly lowered.

EP1222842, which is state of the art according to Art 54(3) EPC, discloses the generation of EUV radiation, in which a fog of microdroplets leaves a heated nozzle, but does not disclose that a jet in condensed state leaves the nozzle.

### Summary of the Invention

It is therefore an object of the present invention to provide a method and an apparatus for stable and uncomplicated generation of X-ray or EUV radiation. More specifically, the invention should provide for low pulse-to-pulse fluctuations in the generated X-ray or EUV radiation flux, low erosion of the jet-generating outlet, as well as low self-absorption of the generated radiation.

It is also an object to provide an apparatus for generating X-ray or EUV radiation that is compact, inexpensive, generates radiation at a relatively high average power and has a minimum production of debris.

A further object is to provide a method and an apparatus which produces X-ray or EUV radiation which is suitable for EUV projection lithography and proximity lithography.

One more object of the invention is to permit use of the method and the apparatus in microscopy, materials science, biomedical and medical diagnostics.

These and other objects, which will be apparent from the following specification, are wholly or partially achieved by the method and the apparatus according to the independent claims. The dependent claims define preferred embodiments.

It has been found that controlling the temperature of the outlet, normally heating the same, has the effect of considerably improving the directional stability of the generated jet. Thus, the invention allows for low pulse-to-pulse fluctuations in the generated X-ray or EUV radiation flux, increased average power, as well as increased spatial stability of the radiating beam-jet-interaction area. The directionally stable jet also allows for a large distance between the outlet and the beam-jet-interaction area, thereby minimizing both erosion of the outlet and self-absorption of the generated radiation. A "large distance" in this context is typically at least a few millimeters. In view of the large distance made possible by the invention, the power of the energy beam might be increased without causing undesired heating of the target generator. Thus, the invention allows for a higher X-ray and EUV flux. Further, the invention allows for use of several new substances and, thus, for stable generation of radiation in new wavelength ranges.

These advantages are obtained while retaining many of the advantages of the prior art technologies, as discussed by way of introduction, for example a great reduction of debris, excellent geometric access, a possibility of long-term operation without interruption by providing new target material continuously through the jet, a possibility of using lasers of high repetition rates, which increases the average power of the generated X-ray or EUV radiation.

The inventive control of the temperature of the outlet should preferably be effected with minimum influence on the temperature of the substance inside the jet-generating outlet, since such influence might cause boiling or a modification of the hydrodynamic properties of the substance, which potentially might lead to instabilities in the generation of the jet, for example potentially undesired spray formation.

According to one preferred embodiment, the temperature of the outlet is controlled by means of ohmic heating, for example by applying a voltage to an electrically conducting resistive wire arranged around and preferably in contact with the outlet, or by applying the voltage to a portion of the outlet itself. This embodiment is advantageous in its simplicity and ruggedness. By means of thin wires or evaporated electrodes it is possible to localize the generated heat close to the outlet opening.

According to another preferred embodiment, the temperature of the outlet is controlled by directing radiation energy, for example laser radiation or microwaves, onto the outlet which is heated by absorption of this radiation energy. This embodiment provides for non-intrusive heating of the outlet, in that no new material needs to be mechanically introduced at the outlet, and can be precisely controlled to heat only the outlet opening, if desired. Preferably, the outlet is treated for enhanced and/or more localized absorption of the radiation energy, for example by providing an absorbing or conducting arrangement, such as a coating or an antenna, on the outlet.

Without committing oneself to a theory, it is assumed that the results regarding the improved directional stability of the generated jet can be explained by the following model. When the substance leaves the outlet, the thus-formed jet, as well as any liquid wetting the outlet, undergoes evaporative cooling. This results in the outlet being cooled, leading to uncontrolled deposition of frozen material on, or close to, the outlet orifice. Such frozen material could induce the stochastic directional instability described above. Heating of the outlet is believed to minimize such deposition of frozen material.

According to a further preferred embodiment of the invention, the jet leaves the outlet in a condensed, i.e. liquid or frozen, state. This allows for collimated transport of target material far from the outlet. To form such a jet of condensed matter, it is preferred to urge a substance in a liquid state through the jet-forming outlet. The substance used in the invention could be a medium which is in a liquid state both at room temperature and the temperature prevailing at the generation of the jet. This medium could also be a solution comprising solids and a suitable carrier fluid. In a particularly preferred embodiment, however, the substance is a medium which is in a gaseous state at room temperature, but which is cooled to a liquid state before being urged through the outlet to form the jet. This type of medium can, by means of the invention, be used in an uncomplicated way for stable generation of X-ray or EUV radiation at previously unaccessible wavelengths. By using an inert gas, in particular a noble gas, the damages caused by debris can be reduced significantly.

It should be noted, however, that the jet can be in any suitable state (gaseous, liquid, or solid) when interacting with the energy beam.

According to one embodiment of the invention, the energy beam is directed onto a spatially continuous portion of the jet. This can be achieved, for instance, by generating a spatially completely continuous jet, and by directing the energy beam onto the actual jet before it spontaneously breaks up into droplets or a spray. Alternatively, it is conceivable to generate a pulsed or semicontinuous jet consisting of separate, spatially continuous portions each having a length that significantly exceeds the diameter. In both cases, the jet might be frozen due to evaporative cooling before interacting with the energy beam.

An alternative embodiment include directing the energy beam onto one or more droplets, or a spray, which could be formed spontaneously, or by stimulation, from the jet.

Thus, the energy beam can, within the scope of the invention, interact with any formation emanating from the jet, be it gaseous, liquid or solid, spatially continuous, droplets, or a spray of droplets or clusters.

The energy beam is preferably a beam of electromagnetic radiation, such as laser radiation, which interacts with the jet and heats it to a plasma-forming temperature. It is also conceivable to use a beam of electrons as energy beam, wherein EUV or X-ray radiation is generated either by the electrons heating the jet to a plasma-forming temperature, or by direct conversion of the electron-beam energy to Bremsstrahlung and characteristic line emission, essentially without the need of heating the jet to a plasma-forming temperature.

The present invention is based on the need for compact and intensive X-ray or EUV sources for, inter alia, lithography, microscopy, materials science and medical diagnostics. Wavelength ranges of particular interest for such applications are approximately 1-2 nm (proximity lithography), 2.3-4.4 nm (X-ray microscopy), 10-15 nm (EUV projection lithography) and 0.01-20 nm (materials science, for instance photoelectron spectroscopy or X-ray fluorescence, or biomedical applications such as X-ray diffraction or medical diagnostics). The generation of radiation in these wavelength ranges with high conversion efficiency by means of laser-produced plasma generally necessitates laser intensities around 10¹⁰-10¹⁵ W/cm². In order to achieve such intensities with compact laser systems, the laser radiation is focused to a diameter of about five to a few hundred micrometers. Thus, the target can be made microscopic, provided that it is spatially stable. The small dimensions contribute to effective utilization of the target material, which, among other things, results in a drastic reduction of debris. By using short-pulsed laser radiation, for example in the femtosecond range, harder X-rays may be generated.

The method and apparatus according to the invention is particularly, but not exclusively, suited for EUV projection lithography which requires irradiation in the wavelength range of approximately 10-15 nm. Such radiation can be generated, by means of the invention, by using xenon as target material.

By using different target materials in a method or an apparatus according to the invention, EUV and X-ray radiation can be generated at suitable wavelengths for a number of different applications. Examples of such applications are X-ray microscopy, materials science (e.g. photoelectron microscopy and X-ray fluorescence), EUV projection lithography, proximity X-ray lithography, medical X-ray diagnostics or crystal analysis.

### Brief Description of the Drawings

The invention will now be described for the purpose of exemplification with reference to the accompanying schematic drawings, which illustrate a currently preferred embodiment and in which
Fig. 1 illustrates a preferred embodiment of the inventive apparatus for generating X-ray or EUV radiation from a stable jet in a low-pressure chamber employing ohmic heating close to the nozzle orifice;
Fig. 2 shows the flux of generated X-ray radiation over time in a prior art apparatus, i.e. without stabilization heating; and
Fig. 3 shows the flux of generated X-ray radiation over time in the apparatus of Fig. 1, i.e. with stabilization heating.

### Description of Preferred Embodiments

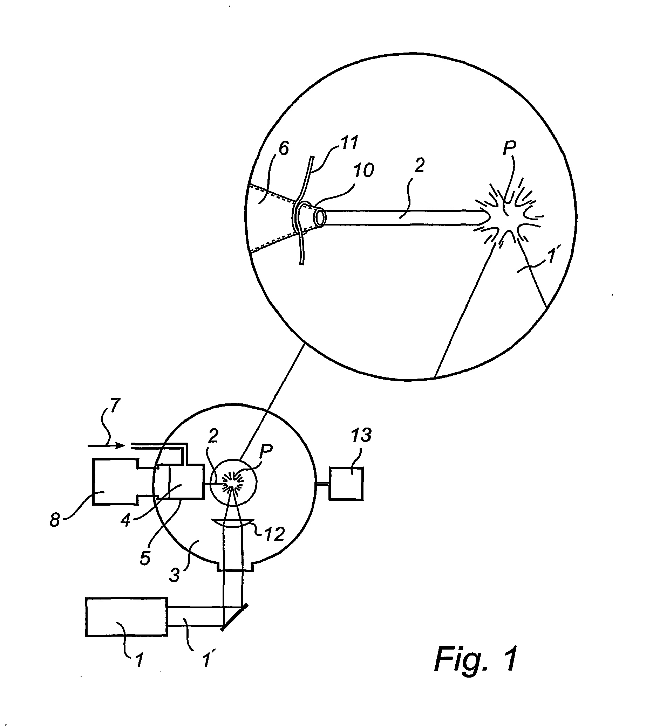

The method and the apparatus according to the invention are basically illustrated in Fig. 1. Below, xenon is used as an example but the invention may be operated with many other substances, of which liquefied gases are believed to be the most important, as discussed in the end of this section.

A laser 1 generates one or more pulsed laser beams 1' that are focused from one or more directions on a jet 2 of liquefied xenon liquid, which serves as target. For reasons of clarity, only one laser beam 1' is shown in Fig. 1. The beam-jet-interaction produces a plasma P emitting the desired X-ray and EUV radiation. The actual production of X-rays usually takes place at low pressure, to prevent emitted soft X-ray or EUV radiation from being absorbed. For certain X-ray or EUV wavelengths, the laser-plasma production may be operated in a gaseous environment. This gaseous environment may be local around the area of beam-jet-interaction. Low pressure is often preferable to eliminate laser-induced breakdowns in front of the jet 2 or to reduce self-absorption of the emitted radiation.

The microscopic jet 2 of liquid xenon is spatially continuous and is formed in a vacuum chamber 3, as shown in Fig. 1. In general, liquid xenon 4 is urged under high pressure (usually 5-500 atmospheres) from a pump (not shown) or a pressure vessel 5 through a small nozzle 6 having an orifice diameter which usually is smaller than about 100 µm and typically a few to up to a few tens of micrometers. This results in a microscopic jet 2 of liquid of essentially the same diameter as the orifice diameter and with a speed of about ten m/s to a few hundred m/s. In one arrangement (not shown), the liquid xenon is produced separately and then forced through the nozzle by a pump or other pressure-producing arrangement. Alternatively, as shown in Fig. 1, the pressure of gaseous xenon 7 itself is used as the driver. Here, xenon gas is forced at a pressure of about 5-100 bar into the pressure vessel 5 which is cooled to about 160-200 K by a Gifford-McMahon-type or other cold head 8. The glass capillary nozzle 6 is attached directly to the pressure vessel 5, producing the microscopic jet 2 of liquid xenon in the low-pressure chamber 3.

The laser beam 1' is controlled to interact with the spatially continuous jet 2. For most liquids, the jet 2 propagates in the chamber 3 in a given direction towards a break-up point (not shown), at which it should spontaneously separate into droplets or a spray. In the exemplifying embodiment shown in Fig. 1, the laser beam 1' is focused on the jet 2 upstream of any such break-up point. For many cryogenic liquids, such as xenon, the jet 2 is rapidly cooled by evaporation as it leaves the nozzle 6, and in many cases the jet 2 freezes close to the nozzle 6 so that no droplets are formed. In that case, the laser beam 1' could be focused on a spatially continuous portion of the thus frozen jet 2.

For generation of X-ray emission in the wavelength range around 1-5 nm, a laser intensity of about 10¹²-10¹⁵ W/cm² is required while 10¹⁰-10¹³ W/cm² are usually preferable for the EUV range. Suitable laser systems for this purpose in the visible, ultraviolet and near infrared wavelength range are commercially available with repetition rates of 10-10000 Hz, and systems having a higher repetition rate are being developed at present.

As pointed out above, the jet may exhibit poor directional stability, thus creating unstable laser-plasma generation. To this end, the tip 10 of the nozzle 6 is heated locally, i.e. close to the nozzle orifice, by some means described below.

The heating of the nozzle tip 10 is preferably local since a general heating of the liquid xenon could result in a spray being formed instead of a spatially continuous jet 2. There are several methods to induce such local heating. One is to resistively heat the tip 10 by applying a thin resitive wire 11 (diameter of a few microns or larger) at the nozzle tip 10 and supply a current through the wire 11. The current, and thus the heating, should be tuned so that the hydrodynamic properties of the flowing liquid xenon inside the nozzle 6 are not markedly changed while the orifice temperature is raised sufficiently to improve the directional stability of the jet 2, presumably by removing evaporation-produced frozen material or fragments on the nozzle orifice. Alternatively, the resistive wire 11 can be exchanged for electrodes (not shown) with proper resistivity that are evaporated at the nozzle tip 10. Other methods of heating the tip 10 include local absorption of cw laser light or other electromagnetic radiation that is focussed on the tip 10. In this context, it is preferred that the outlet is treated to enhance and/or further localize the absorption of the radiation energy, for example by providing an absorbing or conducting arrangement, such as a coating or an antenna (not shown), on the tip 10. Pulsed laser light may also be used, and in this case it cannot be ruled out that any improved directional stability also depends on other factors than just heating, for example ablation of frozen material.

The heating as described above results in sufficient spatial stability (± a few micrometers) to permit laser-plasma production with a laser beam 1' focused to approximately the same size as the diameter of the jet 2.

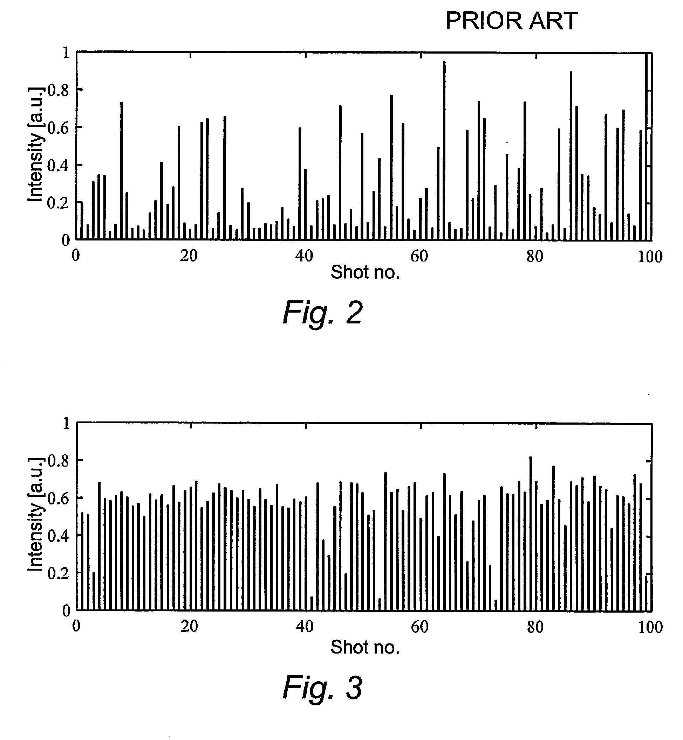

The effectiveness of the invention is further evidenced by the experimental results presented in Figs 2 and 3. Fig. 2 shows the flux of the generated radiation over time in an apparatus operating with laser-plasma production from a continuous jet of liquid xenon, but without any heating of the nozzle orifice. Fig. 3 shows the flux of the generated radiation over time in a corresponding apparatus with heating of the nozzle orifice. Evidently, the heating reduces pulse-to-pulse fluctuations in the generated X-ray or EUV radiation flux.

In the embodiment shown in Fig. 1, the laser beam 1' is focused with a spherical lens 12 to a point having a diameter of about five to a few hundred micrometers. Given the speed of the jet 2 of liquid, the main part of the liquid 2 will thus not be used for laser plasma production, which for many liquids results in an increase of pressure in the vacuum chamber 3 owing to evaporation. Low pressure is maintained with a vacuum pump 13, which typically keeps the chamber pressure at 10⁻³-10⁻⁴ mbar during operation. Additional efforts to keep the pressure low may include, for instance, a cold trap (not shown) catching the non-used liquid. Another means is the use of a differential pumping scheme, which also may include recycling of the xenon gas, which is attractive from a cost-of-target perspective. Alternatively (not shown), the nozzle 6 can be positioned outside the main vacuum chamber 3 and inject the jet 2 through a very small aperture. In that case, a mechanical chopper or electric deflection means (not shown) outside the main vacuum chamber 3 can be used to supply merely the desired amount of liquid to the main vacuum chamber 3.

It should be noted that the above-description is only given for the purpose of illustration, and that many modifications are conceivable within the scope of the invention. For example, an elongated laser focus might be formed over a certain length of the jet, for example by means of one or more cylinder lenses (not shown) in combination with one or more spherical lenses, resulting in an elongated EUV emitting plasma. Semicontinuous or pulsed jets of liquid may, within the scope of the invention, be applicable in special cases. This type of jet consists of separate, spatially continuous portions, which are generated by ejecting the liquid through the nozzle during short periods of time only. In contrast to some of the methods described above, this requires some type of valve (not shown) to supply the liquid xenon to the nozzle.

Above, the generation of a directionally stable liquid jet of liquefied gas for laser-plasma production of X-ray and EUV radition has been described by using xenon as an example. Xenon is believed to be especially important due to its high Z (resulting in high conversion efficiency), its inert noble gas character (resulting in minimum damage to sensitive components positioned close to the plasma), and its suitable emission spectrum (that matches the requirements of EUV projection lithography in the wavelength range of 10-15 nm wavelength, and proximity lithography in the wavelength range of 1-2 nm).

Without limiting the invention to any examples, it should be mentioned that other liquefied gases may be used for directionally stable laser-plasma liquid-jet-target operation for other specific applications. Liquid nitrogen has a suitable emission spectrum for water-window X-ray microscopy, see for example the article "Cryogenic liquid-jet target for debris-free laser-plasma soft X-ray generation" by Berglund et al, published in Rev. Sci. Instrum. 69, p. 2361, 1998. Argon emits at a few keV, having potential use in X-ray absorption and fluorescence studies. Oxygen and nitrogen might be used for surface sensitive photoelectron spectroscopy. Heavy target elements, especially in combination with high peak-power lasers, will result in higher energy emission, which may be suitable for, e.g., X-ray diffraction for crystallography or protein-structure determination.

It should be noted that the directional stability of the jet might be improved by other means minimizing the deposition of frozen material on, or close to, the outlet orifice. For example, a protective coating prohibiting any deposition (wetting) of target liquid could be provided on the outlet, preferably close to the outlet orifice. Alternatively, or additionally, the geometrical shape of outlet could be optimized to prohibit such deposition (wetting). For example, the orifice-defining distal end wall of the outlet could be inclined to the longitudinal direction of the outlet. In special cases, these outlet coating/shaping measures could be used without the inventive heating of the outlet.

## Claims

1. A method of generating X-ray or EUV radiation, comprising the steps of urging a substance through an outlet (6) to generate a jet (2) in a direction from the outlet (6), wherein the jet (2) leaves the outlet (6) in a condensed state and directing at least one energy beam (1') onto the jet (2), the energy beam (1') interacting with the jet (2) to generate said X-ray or EUV radiation, **characterized by** the further step of controlling the temperature of said outlet (6) by heating the same, such that the stability of the jet (2) is improved.

2. A method as set forth in claim 1, wherein said step of controlling the temperature comprises effecting ohmic heating of the outlet (6), preferably at an orifice thereof.

3. A method as set forth in claim 1, wherein said step of controlling the temperature comprises directing radiation energy onto said outlet (6).

4. A method as set forth in any one of the preceding claims, wherein the substance comprises a gas which is cooled to a liquid state before being urged through said outlet (6).

5. A method as set forth in claim 4, therein the gas is an essentially inert gas, such as a noble gas.

6. A method as set forth in any one of claims 1-5, wherein the energy beam (1') is directed onto a spatially continuous portion of the jet (2).

7. A method as set forth in any one of claims 1-5, wherein the energy beam (1') is directed onto at least one droplet of the jet (2).

8. A method as set forth in any one of claims 1-5, wherein the energy beam (1') is directed onto a spray of droplets or clusters formed from the jet (2).

9. A method as set forth in any one of the preceding claims, wherein the jet (2) is cooled by evaporation to a frozen state, and the energy beam (1') is directed onto a frozen portion of the jet (2).

10. A method as set forth in any one of the preceding claims, wherein said energy beam (1') comprises pulsed laser radiation which interacts with the jet (2) to form a plasma (P) emitting said X-ray or EUV radiation.

11. A method as set forth in any one of the preceding claims, wherein said energy beam (1') is focused on the jet (2) to essentially match a transverse dimension of the energy beam (1') to a transverse dimension of the jet (2).

12. A method as set forth in claim 6, wherein the energy beam (1') is focused to essentially coincide with said spatially continuous portion over a length thereof.

13. An apparatus for generating X-ray or EUV radiation, comprising an energy source (1) arranged to emit at least one energy beam (1'), a target generator (4-11) arranged to urge a substance through an outlet (6) to generate a target in the form of a jet (2) in a direction from the outlet (6), wherein the target generator (4-11) is adapted to generate the jet (2) such that it is in a condensed state when leaving the outlet (6) and a beam controller (12) operative to direct the energy beam (1') emitted by the energy source onto the target jet (2) generated by the target generator, said X-ray or EUV radiation being generated by the energy beam (1') interacting with the jet (2), **characterized in that** the target generator (4-11) comprises a means (11) for controlling the temperature of said outlet (6) by heating the same, such that the stability of the jet (2) is improved.

14. An apparatus as set forth in claim 13, wherein the temperature-controlling means comprises a resistive element (11) arranged in association with said outlet (6), and a power supply connected to the resistive element (11) to heat the outlet (6) by ohmic heating.

15. An apparatus as set forth in claim 13, wherein the temperature-controlling means (11) comprises a radiation heater directing radiation energy onto said outlet (6).

16. An apparatus as set forth in claim 15, wherein the outlet (6) comprises means providing for enhanced and/or confined absorption of the radiation energy.

17. An apparatus as set forth in any one of claims 13-16, wherein the substance comprises a gas, the target generator (4-11) being adapted to cool said gas to a liquid state before urging it through the outlet (6).

18. An apparatus as set forth in claim 17, wherein the gas is an essentially inert gas, such as a noble gas.

19. An apparatus as set forth in any one of claims 13-18, wherein the target generator (4-11) is controllable to provide a spatially continuous portion, at least one droplet, or a spray of droplets or clusters for the energy beam (1') to interact with.

20. An apparatus as set forth in any one of claims 13-19, wherein the outlet (6) is arranged to generate the jet (2) in a chamber (3), and wherein a conditioning means (13) is arranged to control the atmosphere in the chamber (3) such that the jet (2) is cooled by evaporation to a frozen state on entry into the chamber (3).

21. An apparatus as set forth in any one of claims 13-20, wherein the energy source comprises a laser (1) emitting at least one beam (1') of pulsed laser radiation, said beam (1'), when directed onto the jet, interacting therewith to form a plasma (P) emitting said X-ray or EUV radiation.

22. An apparatus as set forth in any one of claims 13-21, wherein the beam controller (12) is adapted to focus said energy beam (1') on the jet (2) to essentially match a transverse dimension of the energy beam (1') to a transverse dimension of the jet (2).

23. An apparatus as set forth in claim 19, wherein the beam controller (12) is adapted to focus said energy beam (1') to essentially coincide with said spatially continuous portion over a length thereof.

24. A method comprising generating radiation by a method as set forth in any one of claims 1-12 or an apparatus as set forth in any one of claims 13-23 and using it for X-ray microscopy.

25. A method comprising generating radiation by a method as set forth in any one of claims 1-12 or an apparatus as set forth in any one of claims 13-23 and using it for proximity lithography.

26. A method comprising generating radiation by a method as set forth in any one of claims 1-12 or an apparatus as set forth in any one of claims 13-23 and using it for EUV projection lithography.

27. A method comprising generating radiation by a method as set forth in any one of claims 1-12 or an apparatus as set forth in any one of claims 13-23 and using it for photoelectron spectroscopy.

28. A method comprising generating radiation by a method as set forth in any one of claims 1-12 or an apparatus as set forth in any one of claims 13-23 and using it for X-ray fluorescence.

29. A method comprising generating radiation by a method as set forth in any one of claims 1-12 or an apparatus as set forth in any one of claims 13-23 and using it for X-ray diffraction.

30. A method comprising generating radiation by a method as set forth in any one of claims 1-12 or an apparatus as set forth in any one of claims 13-23 and using it for medical diagnostics.

## Patentansprüche

1. Verfahren zum Erzeugen von Röntgen- oder EUV-Strahlung, umfassend die Schritte des Drückens einer Substanz durch einen Auslass (6), um einen Strahl (2) in einer Richtung weg vom Auslass (6) zu erzeugen, wobei der Strahl den Auslass (6) in einem verdichteten Zustand verlässt, und des Richtens wenigstens eines Energiestrahls (1') auf den Strahl (2), wobei der Energiestrahl (1') mit dem Strahl (2) interagiert, um die Röntgen- oder EUV-Strahlung zu erzeugen, **gekennzeichnet durch** den weiteren Schritt des Steuerns der Temperatur des Auslasses (6) **durch** Erwärmen desselben, so dass die Stabilität des Strahls (2) verbessert wird.

2. Verfahren nach Anspruch 1, bei dem der Schritt des Steuerns der Temperatur das Ausführen einer ohmschen Erwärmung des Auslasses (6) vorzugsweise an einer Öffnung desselben umfasst.

3. Verfahren nach Anspruch 1, bei dem der Schritt des Steuerns der Temperatur das Richten von Strahlungsenergie auf den Auslass (6) umfasst.

4. Verfahren nach einem der vorhergehenden Ansprüche, bei dem die Substanz ein Gas enthält, das auf einen flüssigen Zustand gekühlt wird, bevor es durch den Auslass (6) gedrückt wird.

5. Verfahren nach Anspruch 4, bei dem das Gas ein im wesentlichen inertes Gas, wie etwa ein Edelgas ist.

6. Verfahren nach einem der Ansprüche 1 bis 5, bei dem der Energiestrahl (1') auf einen räumlich kontinuierlichen Abschnitt des Strahls (2) gerichtet wird.

7. Verfahren nach einem der Ansprüche 1 bis 5, bei dem der Energiestrahl (1') auf wenigstens ein Tröpfchen des Strahls (2) gerichtet wird.

8. Verfahren nach einem der Ansprüche 1 bis 5, bei dem der Energiestrahl (1') auf Nebel aus Tröpfchen oder Cluster gerichtet wird, die aus dem Strahl (2) ausgebildet werden.

9. Verfahren nach einem der vorhergehenden Ansprüche, bei dem der Strahl (2) durch Verdampfung auf einen gefrorenen Zustand gekühlt wird und der Energiestrahl (1') auf einen gefrorenen Abschnitt des Strahls (2) gerichtet wird.

10. Verfahren nach einem der vorhergehenden Ansprüche, bei dem der Energiestrahl (1') gepulste Laserstrahlung enthält, die mit dem Strahl (2) interagiert, um ein Plasma (P) auszubilden, das die Röntgen- oder EUV-Strahlung emittiert.

11. Verfahren nach einem der vorhergehenden Ansprüche, bei dem der Energiestrahl (1') auf den Strahl (2) fokussiert wird, damit eine Querabmessung des Energiestrahls (1') mit einer Querabmessung des Strahls (2) im wesentlichen übereinstimmt.

12. Verfahren nach Anspruch 6, bei dem der Energiestrahl (1') fokussiert wird, um im wesentlichen mit dem räumlich kontinuierlichen Abschnitt über eine Länge desselben übereinzustimmen.

13. Vorrichtung zum Erzeugen von Röntgen- oder EUV-Strahlung, enthaltend eine Energiequelle (1), die dazu eingerichtet ist, wenigstens einen Energiestrahl (1') zu emittieren, eine Target-Erzeugungseinrichtung (4-11), die dazu eingerichtet ist, eine Substanz durch einen Auslass (6) zu drücken, um ein Target in Gestalt eines Strahls (2) in einer Richtung weg von dem Auslass (6) zu erzeugen, wobei die Target-Erzeugungseinrichtung (4-11) dazu eingerichtet ist, den Strahl (2) derart zu erzeugen, dass er sich in einem verdichteten Zustand befindet, wenn der den Auslass (6) verlässt, und eine Strahlsteuereinheit (12), die in Funktion den Energiestrahl (1'), der von der Energiequelle emittiert wird, auf den Target-Strahl (2) richtet, der von der Target-Erzeugungseinrichtung erzeugt wird, wobei die Röntgen- oder EUV-Strahlung durch den Energiestrahl (1') erzeugt wird, der mit dem Strahl (2) interagiert, **dadurch gekennzeichnet, dass** die Target-Erzeugungseinrichtung (4-11) eine Einrichtung (11) zum Steuern der Temperatur des Auslasses (6) durch Erwärmen desselben enthält, so dass die Stabilität des Strahls (2) verbessert ist.

14. Vorrichtung nach Anspruch 13, bei der die Temperatursteuereinrichtung ein Widerstandselement (11), das in Zuordnung mit dem Auslass (6) angeordnet ist, sowie eine Stromversorgung enthält, die mit dem Widerstandselement (11) verbunden ist, um den Auslass (6) durch ohmsche Erwärmung zu erwärmen.

15. Vorrichtung nach Anspruch 13, bei der die Temperatursteuereinrichtung (11) eine Strahlungserwärmungseinrichtung enthält, die Strahlungsenergie auf den Auslass (6) richtet.

16. Vorrichtung nach Anspruch 15, bei der der Auslass (6) eine Einrichtung enthält, die für eine verbesserte und/oder begrenzte Absorption der Strahlungsenergie sorgt.

17. Vorrichtung nach einem der Ansprüche 13 bis 16, bei der die Substanz ein Gas enthält, wobei die Target-Erzeugungseinrichtung (4-11) dazu eingerichtet ist, das Gas auf einen flüssigen Zustand zu kühlen, bevor sie es durch den Auslass (6) drückt.

18. Vorrichtung nach Anspruch 17, bei der das Gas ein im wesentlichen inertes Gas, wie etwa ein Edelgas ist.

19. Vorrichtung nach einem der Ansprüche 13 bis 18, bei der die Target-Erzeugungseinrichtung (4-11) derart gesteuert werden kann, dass sie einen räumlich kontinuierlichen Abschnitt, wenigstens ein Tröpfchen, oder einen Nebel von Tröpfchen oder Cluster für den Energiestrahl (1') zu Interaktion damit bereitstellt.

20. Vorrichtung nach einem der Ansprüche 13 bis 19, bei der der Auslass (6) dazu eingerichtet ist, den Strahl (2) in einer Kammer (3) zu erzeugen, und eine Aufbereitungseinrichtung (13) dazu eingerichtet ist, die Atmosphäre in der Kammer (3) derart zu steuern, dass der Strahl (2) durch Verdampfung auf einen gefrorenen Zustand beim Eintritt in die Kammer (3) gekühlt wird.

21. Vorrichtung nach einem der Ansprüche 13 bis 20, bei der die Energiequelle einen Laser (1) enthält, der wenigstens einen Strahl (1') einer gepulsten Laserstrahlung emittiert, wobei der Strahl (1'), wenn er auf den Strahl gerichtet ist, mit diesem interagiert, um ein Plasma (P) zu bilden, das die Röntgen- oder EUV-Strahlung emittiert.

22. Vorrichtung nach einem der Ansprüche 13 bis 21, bei der die Strahlsteuereinheit (12) dazu eingerichtet ist, den Energiestrahl (1') auf dem Strahl (2) zu fokussieren, damit eine Querabmessung des Energiestrahls (1') mit einer Querabmessung des Strahls (2) im wesentlichen übereinstimmt.

23. Vorrichtung nach Anspruch 19, bei der die Strahlsteuereinheit (12) dazu eingerichtet ist, den Energiestrahl (1') zu fokussieren, um im wesentlichen mit dem räumlich kontinuierlichen Abschnitt über eine Länge desselben übereinzustimmen.

24. Verfahren, umfassend die Erzeugung von Strahlung durch ein Verfahren nach einem der Ansprüche 1 bis 12 oder eine Vorrichtung nach einem der Ansprüche 13 bis 23 und Verwenden derselben für die Röntgenmikroskopie.

25. Verfahren, umfassend die Erzeugung von Strahlung durch ein Verfahren nach einem der Ansprüche 1 bis 12 oder eine Vorrichtung nach einem der Ansprüche 13 bis 23 und Verwenden derselben für die Proximity-Lithografie.

26. Verfahren, umfassend die Erzeugung von Strahlung durch ein Verfahren nach einem der Ansprüche 1 bis 12 oder eine Vorrichtung nach einem der Ansprüche 13 bis 23 und Verwenden derselben für die EUV-Projektionslithografie.

27. Verfahren, umfassend die Erzeugung von Strahlung durch ein Verfahren nach einem der Ansprüche 1 bis 12 oder eine Vorrichtung nach einem der Ansprüche 13 bis 23 und Verwenden derselben für die Fotoelektronenspektroskopie.

28. Verfahren, umfassend die Erzeugung von Strahlung durch ein Verfahren nach einem der Ansprüche 1 bis 12 oder eine Vorrichtung nach einem der Ansprüche 13 bis 23 und Verwenden derselben für Röntgenfluoreszenz.

29. Verfahren, umfassend die Erzeugung von Strahlung durch ein Verfahren nach einem der Ansprüche 1 bis 12 oder eine Vorrichtung nach einem der Ansprüche 13 bis 23 und Verwenden derselben für Röntgendiffraktion.

30. Verfahren, umfassend die Erzeugung von Strahlung durch ein Verfahren nach einem der Ansprüche 1 bis 12 oder eine Vorrichtung nach einem der Ansprüche 13 bis 23 und Verwenden derselben bei medizinischer Diagnostik.

## Revendications

1. Procédé de production de rayons X ou de rayonnement EUV, comprenant les étapes consistant à pousser une substance à travers une sortie (6) pour générer un jet (2) dans une direction partant de la sortie (6), le jet (2) quittant la sortie (6) à l'état condensé, et à diriger au moins un faisceau d'énergie (1') sur le jet (2), le faisceau d'énergie (1') interagissant avec le jet (2) pour produire lesdits rayons X ou le rayonnement EUV,
**caractérisé par** l'étape supplémentaire consistant à commander la température de ladite sortie (6) en chauffant celle-ci, de façon à améliorer la stabilité du jet (2).

2. Procédé selon la revendication 1, dans lequel ladite étape de commande de la température consiste à effectuer un chauffage ohmique de la sortie (6), de préférence au niveau d'un orifice de celle-ci.

3. Procédé selon la revendication 1, dans lequel ladite étape de commande de la température consiste à diriger l'énergie du rayonnement sur ladite sortie (6).

4. Procédé selon l'une quelconque des revendications précédentes, dans lequel la substance comprend un gaz qui est refroidi à un état liquide avant d'être poussé à travers ladite sortie (6).

5. Procédé selon la revendication 4, dans lequel le gaz est un gaz sensiblement inerte, tel qu'un gaz noble.

6. Procédé selon l'une quelconque des revendications 1 à 5, dans lequel le faisceau d'énergie (1') est dirigé sur une partie spatialement continue du jet (2).

7. Procédé selon l'une quelconque des revendications 1 à 5, dans lequel le faisceau d'énergie (1') est dirigé sur au moins une gouttelette du jet (2).

8. Procédé selon l'une quelconque des revendications 1 à 5, dans lequel le faisceau d'énergie (1') est dirigé sur une pulvérisation de gouttelettes ou d'agrégats formée à partir du jet (2).

9. Procédé selon l'une quelconque des revendications précédentes, dans lequel le jet (2) est refroidi par évaporation à un état de gel, et le faisceau d'énergie (1') est dirigé sur une partie gelée du jet (2).

10. Procédé selon l'une quelconque des revendications précédentes, dans lequel ledit faisceau d'énergie (1') comprend un rayonnement laser pulsé qui interagit avec le jet (2) pour former un plasma (P) émettant lesdits rayons X ou rayonnement EUV.

11. Procédé selon l'une quelconque des revendications précédentes, dans lequel ledit faisceau d'énergie (1') est focalisé sur le jet (2) pour sensiblement adapter une dimension transversale du faisceau d'énergie (1') à une dimension transversale du jet (2).

12. Procédé selon la revendication 6, dans lequel le faisceau d'énergie (1') est focalisé pour coïncider sensiblement avec ladite partie spatialement continue sur une longueur de celle-ci.

13. Dispositif de production de rayons X ou d'un rayonnement EUV, comprenant une source d'énergie (1) disposée pour émettre au moins un faisceau d'énergie (1'), un générateur de cible (4-11) disposé pour pousser une substance à travers une sortie (6) pour générer une cible sous la forme d'un jet (2) dans une direction partant de la sortie (6), le générateur de cible (4-11) étant destiné à produire le jet (2) de façon qu'il soit à l'état condensé lorsqu'il quitte la sortie (6), et un dispositif de commande de faisceau (12) conçu pour diriger le faisceau d'énergie (1') émis par la source d'énergie sur le jet cible (2) généré par le générateur de cible, lesdits rayons X ou rayonnement EUV étant produits par le faisceau d'énergie (1') interagissant avec le jet (2), **caractérisé en ce que** le générateur de cible (4-11) comprend un moyen (11) pour commander la température de ladite sortie (6) en chauffant celle-ci, de façon à améliorer la stabilité du jet (2).

14. Dispositif selon la revendication 13, dans lequel le moyen de commande de température comprend un élément résistif (11) disposé en association avec ladite sortie (6), et une alimentation connectée à l'élément résistif (11) pour chauffer la sortie (6) par chauffage ohmique.

15. Dispositif selon la revendication 13, dans lequel le moyen de commande de température (11) comprend un dispositif de chauffage par rayonnement dirigeant l'énergie de rayonnement sur ladite sortie (6).

16. Dispositif selon la revendication 15, dans lequel la sortie (6) comprend des moyens assurant une absorption améliorée et/ou confinée de l'énergie de rayonnement.

17. Dispositif selon l'une quelconque des revendications 13 à 16, dans lequel la substance comprend un gaz, le générateur de cible (4-11) étant destiné à refroidir ledit gaz à un état liquide avant de le pousser à travers la sortie (6).

18. Dispositif selon la revendication 17, dans lequel le gaz est un gaz sensiblement inerte, tel qu'un gaz noble.

19. Dispositif selon l'une quelconque des revendications 13 à 18, dans lequel le générateur de cible (4-11) peut être commandé pour fournir une partie spatialement continue, au moins une gouttelette, ou une pulvérisation de gouttelettes ou d'agrégats pour interaction du faisceau d'énergie (1') avec ceux-ci.

20. Dispositif selon l'une quelconque des revendications 13 à 19, dans lequel la sortie (6) est disposée pour produire le jet (2) dans une chambre (3), et dans lequel un moyen de conditionnement (13) est disposé pour contrôler l'atmosphère dans la chambre (3) de telle façon que le jet soit refroidi par évaporation à un état de gel à son entrée dans la chambre (3).

21. Dispositif selon l'une quelconque des revendications 13 à 20, dans lequel la source d'énergie comprend un laser (1) émettant au moins un faisceau (1') de rayonnement laser pulsé, ledit faisceau (1'), lorsqu'il est dirigé sur le jet, interagissant avec celui-ci pour former un plasma (P) émettant lesdits rayons X ou rayonnement EUV.

22. Dispositif selon l'une quelconque des revendications 13 à 21, dans lequel le dispositif de commande de faisceau (12) est destiné à focaliser ledit faisceau d'énergie (1') sur le jet (2) pour sensiblement adapter une dimension transversale du faisceau d'énergie (1') à une dimension transversale du jet (2).

23. Dispositif selon la revendication 19, dans lequel le dispositif de commande de faisceau (12) est destiné à focaliser ledit faisceau d'énergie (1') pour coïncider sensiblement avec ladite partie spatialement continue sur une longueur de celle-ci.

24. Procédé consistant à produire un rayonnement par un procédé selon l'une quelconque des revendications 1 à 12 ou un dispositif selon l'une quelconque des revendications 13 à 23, et à l'utiliser pour la microscopie à rayons X.

25. Procédé consistant à produire un rayonnement par un procédé selon l'une quelconque des revendications 1 à 12 ou un dispositif selon l'une quelconque des revendications 13 à 23, et à l'utiliser pour la lithographie de proximité.

26. Procédé consistant à produire un rayonnement par un procédé selon l'une quelconque des revendications 1 à 12 ou un dispositif selon l'une quelconque des revendications 13 à 23, et à l'utiliser pour la lithographie par projection d'EUV.

27. Procédé consistant à produire un rayonnement par un procédé selon l'une quelconque des revendications 1 à 12 ou un dispositif selon l'une quelconque des revendications 13 à 23, et à l'utiliser pour la spectroscopie de photoélectrons.

28. Procédé consistant à produire un rayonnement par un procédé selon l'une quelconque des revendications 1 à 12 ou un dispositif selon l'une quelconque des revendications 13 à 23, et à l'utiliser pour la fluorescence X.

29. Procédé consistant à produire un rayonnement par un procédé selon l'une quelconque des revendications 1 à 12 ou un dispositif selon l'une quelconque des revendications 13 à 23, et à l'utiliser pour la diffraction de rayons X.

30. Procédé consistant à produire un rayonnement par un procédé selon l'une quelconque des revendications 1 à 12 ou un dispositif selon l'une quelconque des revendications 13 à 23, et à l'utiliser pour le diagnostic médical.
